# EUROPEAN PATENT APPLICATION

(11) **EP 1 968 195 A1**
(43) Date of publication of application: **10.09.2008**
(21) Application number: 06834928.1
(22) Date of filing: 19.12.2006
(51) Int. Cl.: H03M 1/10

(54) **ANALOG-TO-DIGITAL CONVERTING APPARATUS AND VEHICLE POWER SUPPLY APPARATUS USING THE SAME**

(30) Priority: 28.12.2005 JP 2005377939
(71) Applicant: Matsushita Electric Industrial Co., Ltd., Kadoma-shi, Osaka 571-8501 (JP)
(72) Inventor: MITANI, Y., c/o Matsushita Electric Ind. Co. Ltd., Chuo-ku, Osaka-shi,Osaka 540-6207 (JP); MORITA, K., c/o Matsushita Electric Ind. Co. Ltd., Chuo-ku, Osaka-shi,Osaka 540-6207 (JP); ODAJIMA, Y. c/o Matsushita Electric Ind. Co. Ltd., Chuo-ku, Osaka-shi,Osaka 540-6207 (JP)
(74) Representative: Pautex Schneider, Nicole Véronique
(86) International application number: PCT/JP2006/325218
(87) International publication number: WO 2007/074673

(57) **Abstract**

The A/D conversion apparatus and the vehicle power-supply device using the apparatus calculate errors at a plurality of reference voltages and reference errors prior to error correction. Each reference error is applied to a digital-output range that is divided by digital output corresponding to the reference voltages. In the calculation, when the errors obtained at adjacent reference voltages have same signs, the reference error is determined as an average of the errors obtained at adjacent reference voltages; on the other hand, when the errors obtained at adjacent reference voltages have different signs, the reference error is determined to be zero. The apparatus provides a corrected digital output by subtracting the reference error―which is applied to the digital-output range including the digital output―from the digital output corresponding to analog input voltage.

## Description

### TECHNICAL FIELD

The present invention relates to an analog-to-digital converting apparatus (hereinafter referred to as A/D conversion apparatus) that converts analog input voltage into digital signals and also relates to a vehicle power supply apparatus (hereinafter referred to as power-supply device) using the A/D conversion apparatus that offers emergency power-supply backup to the vehicle load.

### BACKGROUND ART

An A/D conversion apparatus converts analog input voltage into digital signals. Theoretically, the obtained output is directly proportional (i.e., linear) to the analog input voltage; in reality, however, the A/D conversion apparatus often offers "non-linear" output because of an error between the output and the true value under the influence of characteristics off the A/D conversion apparatus itself and noise caused by the peripheral circuits.

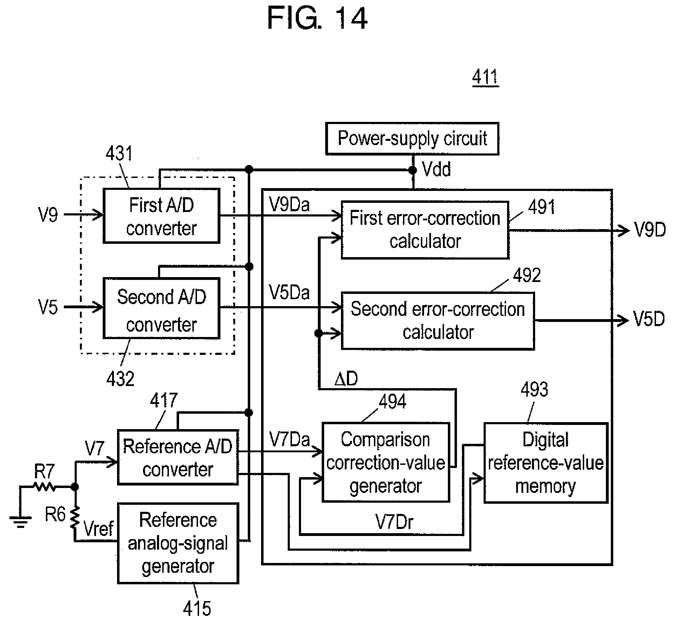

To address the problem above, patent reference 1* discloses a method of correcting the error on the basis of reference voltage. Fig. 14 shows a circuit block diagram of the conventional method.

A/D conversion apparatus 411 in Fig. 14 is mainly formed of A/D converters and calculators.

Here will be described the workings of such structured A/D conversion apparatus 411. Reference analog-signal generator 415 generates voltage Vref, which is divided by resistors R6, R7. Such obtained reference voltage V7 is analog voltage. Receiving voltage V7, reference A/D converter 417 outputs digital output V7Da. Digital output V7Da is fed into comparison correction-value generator 494.

Digital reference-value V7Dr, which is stored as predetermined data in digital reference-value memory 493, is also fed into comparison correction-value generator 494.

Receiving digital output V7Da and digital reference-value V7Dr, comparison correction-value generator 494 calculates error ΔD as a difference between values V7Da and V7Dr.

In the meantime, receiving voltage V9 of arbitrary magnitude, first A/D converter 431 outputs digital output V9Da. Digital output V9Da is fed into first error-correction calculator 491. First error-correction calculator 491 also receives error ΔD from comparison correction-value generator 494. Receiving digital output V9Da and error AD, first error-correction calculator 491 outputs first true-value V9D determined from the calculation: V9D = V9Da - ΔD.

Similarly, receiving voltage V5 of arbitrary magnitude, second A/D converter 432 outputs digital output V5Da. Digital output V5Da is fed into second error-correction calculator 492. Second error-correction calculator 492 also receives error ΔD from comparison correction-value generator 494. Receiving digital output V5Da and error ΔD, second error-correction calculator 492 outputs second true-value V5D determined from the calculation: V5D = V5Da - ΔD. In Fig. 14, voltage Vdd is supplied to each circuit block as the output voltage of the power supply circuit.

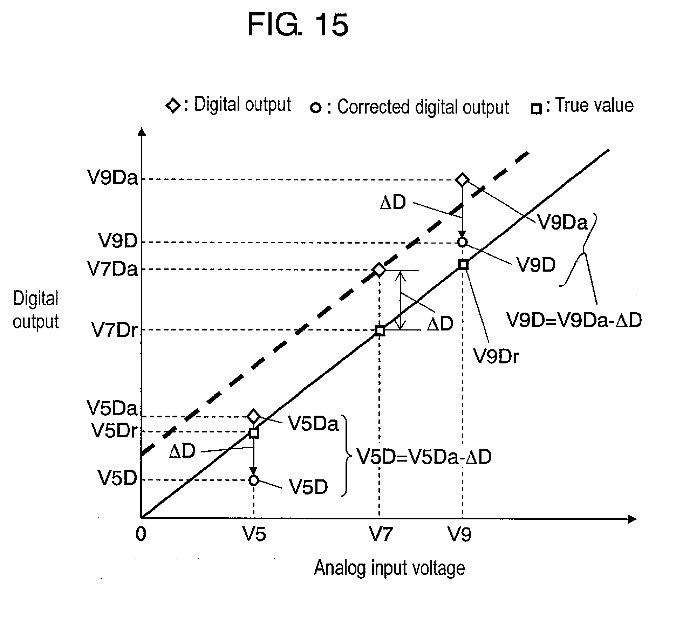

Here will be described the error-correction method in the structure above with reference to Fig. 15. Fig. 15 shows analog input voltage on the horizontal axis and digital output on the vertical axis. The aforementioned process will be described with reference to the graph of Fig. 15.

Firstly, receiving reference voltage V7, reference A/D converter 417 outputs digital output V7Da (indicated by the diamond-shaped point found at a section corresponding to V7Da on the vertical axis of the graph).

Digital reference-value memory 493 stores digital reference-value V7Dr as a predetermined value corresponding to reference voltage V7, which is the true value shown by a square point in Fig. 15. As is described earlier, comparison correction-value generator 494 calculates the difference between V7Dr and V7Da as error ΔD. In the conventional correction method, error ΔD is determined as a fixed value regardless of the magnitude of analog input voltage. Under the assumption, digital output is always found on the thick dot line in Fig. 15. That is, according to the conventional method, digital output is found on the thick dot line upwardly moved, by error ΔD, parallel to the solid line representing true values.

Analog input voltage V9 of arbitrary magnitude is converted into output V9Da by first A/D converter 431. Receiving output V9Da, first error-correction calculator 491 subtracts error ΔD from V9Da and outputs first true-value V9D (shown as the round point in the graph) as a corrected digital output.

Similarly, analog input voltage V5 of arbitrary magnitude is converted into output V5Da by second A/D converter 432. Receiving output V5Da, second error-correction calculator 492 subtracts error ΔD from V5Da and outputs second true-value V5D (shown as another round point in the graph) as a corrected digital output. Through the correction above, an analog input voltage of arbitrary magnitude is converted into a digital output. As a corrected value, digital output V9D (after correction) gets closer to true value V9Dr, compared to digital output V9Da (before correction). It will be understood from the fact that the conventional error-correction method works in an efficient manner.

However, a problem arises in the following case; receiving analog voltage V5 of arbitrary magnitude, second A/D converter 432 offers digital output V5Da (i.e., before correction) that happens to be close to true value V5Dr. Correction in this case has an adversely effect. Digital output V5D after correction is further away from true value V5Dr, so that the error can be increased.

The inconveniency above comes from determining error ΔD as a fixed value. If the A/D converter has high accuracy and provides digital output that linearly varies with uniformly given error ΔD, the conventional correction satisfactorily works; ordinary A/D converters cannot always provide accurate correction with the use of single error ΔD. That is, an A/D conversion apparatus often exhibits characteristics of non-linear error ΔD according to analog input voltage. Such inconveniencies of the conventional method cannot always carry out intended correction but can cause degradation of accuracy in some cases.

Besides, employing such a conventional A/D conversion apparatus for a vehicle power-supply device can develop a further concern on a hydraulic braking system of a vehicle. That is, the recent years' advance in development of hybrid and electric-powered vehicles has been accelerating the shift to an electrically driven hydraulic braking system. In such advanced vehicles, if power supply from the battery as a power source is cut off for some reason, the vehicle can be out of control.

To address the problem above, a suggestion has been made on a vehicle power-supply device. In addition to the battery, the device has a mass storage capacitor as auxiliary power-supply so as to supply electric power in emergency to the control section for electrically driving the braking system of the vehicle.

Such structured vehicle power-supply device monitors operating conditions of the capacitor by detecting capacitor voltage. The voltage detection is carried out by a microcomputer of the control section; in general, an A/D conversion apparatus becomes indispensable. In this case, using the conventional A/D conversion apparatus can cause a problem; in a range with poor accuracy of error correction, as is the case with the application of analog voltage V5 (Fig. 15), the apparatus cannot always provide reliable output.
patent reference 1*: Japanese Patent Unexamined Publication No. 2004-304738

### SUMMARY OF THE INVENTION

The A/D conversion apparatus and the vehicle power-supply device using the A/D conversion apparatus of the present invention carries out error correction on digital output in the following manner. With the use of a plurality of reference voltages, the apparatus determines errors to be applied to each reference voltage, and also determines reference errors to be applied to each digital-output range divided by digital output corresponding to each reference voltage. If the errors corresponding to adjacent reference voltages have same signs, the reference error is calculated as the average of the errors of the adjacent reference voltages; whereas, if the errors corresponding to adjacent reference voltage have different signs, the reference errors is determined to be zero. Receiving an analog input voltage, the apparatus carries out error-correction on obtained digital output by subtracting the reference error, which is applied to the digital-output range that includes the digital output, from the digital output.

With the structure above, the A/D conversion apparatus offers corrected digital output with the use of reference error properly selected from two or more reference errors, providing highly accurate error-correction.

### BRIEF DESCRIPTION OF THE DRAWINGS

Fig. 1 is a circuit block diagram of an A/D conversion apparatus in accordance with a first exemplary embodiment of the present invention.
Fig. 2 shows correlation between analog input voltage and digital output under the first correction state of the A/D conversion apparatus in accordance with the first exemplary embodiment.
Fig. 3 shows correlation between analog input voltage and digital output in a correction example under the first correction state of the A/D conversion apparatus in accordance with the first exemplary embodiment.
Fig. 4 shows correlation between analog input voltage and digital output under the second correction state of the A/D conversion apparatus in accordance with the first exemplary embodiment.
Fig. 5 shows correlation between analog input voltage and digital output in a correction example under the second correction state of the A/D conversion apparatus in accordance with the first exemplary embodiment.
Fig. 6 shows correlation between analog input voltage and digital output under the third correction state of the A/D conversion apparatus in accordance with the first exemplary embodiment.
Fig. 7 shows correlation between analog input voltage and digital output in a correction example under the third correction state of the A/D conversion apparatus in accordance with the first exemplary embodiment.
Fig. 8 is a circuit block diagram of a vehicle power-supply device using the A/D conversion apparatus in accordance with a second exemplary embodiment of the present invention.
Fig. 9 is a circuit block diagram of a vehicle power-supply device using the A/D conversion apparatus in accordance with a third exemplary embodiment of the present invention.
Fig. 10A is a flow chart of the main routine illustrating the workings of the vehicle power-supply device using the A/D conversion apparatus in accordance with the third exemplary embodiment of the present invention.
Fig. 10B is a flow chart of the interrupt routine illustrating the workings of the vehicle power-supply device using the A/D conversion apparatus in accordance with the third exemplary embodiment of the present invention.
Fig. 11 is a circuit block diagram of the vehicle power-supply device using the A/D conversion apparatus in accordance with a fourth exemplary embodiment of the present invention.
Fig. 12 is a circuit block diagram of the vehicle power-supply device using the A/D conversion apparatus in accordance with a fifth exemplary embodiment of the present invention.
Fig. 13 is a flow chart of the main routine illustrating the workings of the vehicle power-supply device using the A/D conversion apparatus in accordance with the fifth exemplary embodiment of the present invention.
Fig. 14 is a circuit block diagram of a conventional A/D conversion apparatus.
Fig. 15 shows correlation between analog input voltage and digital output as a conventional correction example.

### REFERENCE MARKS IN THE DRAWINGS

- 100: microcomputer
- 100C: port controller (controller)
- 101: A/D converter
- 106: multiplexer for reference voltage (selector)
- 109: Zener diode (reference voltage source)
- 110: high accuracy resistor
- 111, 210: vehicle load
- 113, 213: main power-supply
- 114, 214: power-supply backup unit
- 115, 216: capacitor unit
- 116: charging circuit
- 117: discharging circuit
- 118: power-supply selector switch
- 120, 220: A/D conversion apparatus

### DETAILED DESCRIPTION OF THE PREFERRED EMBODIMENTS

The exemplary embodiments of the present invention are described hereinafter with reference to the accompanying drawings.

### (FIRST EXEMPLARY EMBODIMENT)

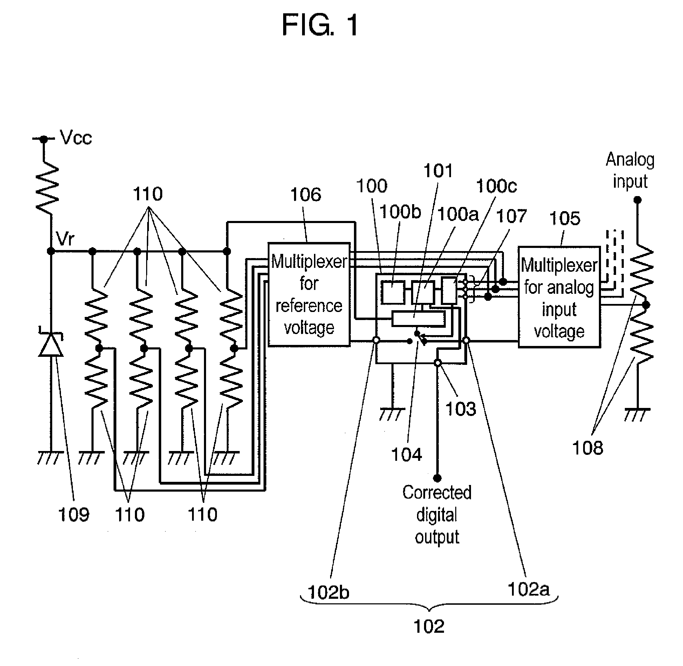

Fig. 1 is a circuit block diagram of an A/D conversion apparatus in accordance with the first exemplary embodiment of the present invention. Microcomputer 100 in Fig. 1 has calculator 100a with 16-bit microprocessing power, internal memory 100b and port controller 100c for controlling an input port and an output port (as will be described later). In addition to the structure above, 10-bit A/D converter 101 is built in microcomputer 100. The structure with a built-in A/D converter shortens the transmission distance between A/D converter 101 and calculator 100a and decreases ill effect caused by noise from outside, thereby enhancing accuracy.

When receiving analog input voltage through selected one port of input ports 102, A/D converter 101 converts it into digital output and sends the output to calculator 100a. Receiving the digital output, calculator 100a carries out error correction on the digital output to obtain corrected digital output. According to the structure of the embodiment, the corrected digital output directly goes out of output port 103, the corrected digital output may be utilized in microcomputer 100.

Selector switch 104, which selects one port from a plurality of input ports 102, is built in microcomputer 100 and controlled by port controller 100c. The structure of the embodiment uses two ports as input ports 102: ports 102a and 102b.

Input ports 102a and 102b are connected to multiplexer 105 for analog input voltage and multiplexer 106 for reference voltage, respectively. The multiplexers serve as selectors for selecting one input. The input selection of multiplexers 105 and 106 is controlled by microcomputer 100; specifically, the input selection is carried out according to a signal fed from selector port 107 connected to controller 100c.

Multiplexer 105 for analog input voltage receives a plurality of analog input voltages. To be specific, before being fed into multiplexer 105, the analog input is divided by resistor 108. This protects multiplexer 105 from receiving analog input beyond the withstand voltage.

It will be understood that other analog inputs―although they are partially shown as dot lines in Fig. 1―are also divided by each resistor before being fed into multiplexer 105.

On the other hand, multiplexer 106 for reference voltage receives a plurality of reference voltages. That is, the reference voltages, which are obtained from output voltage of Zener diode 109 (as a reference voltage source), are fed into A/D converter 101 via multiplexer 106 as a selector.

The structure of the embodiment uses, as shown in Fig. 1, four reference voltages with a magnitude between the ground level (0V) and output voltage of Zener diode 109. Zener diode 109 employed here has an output voltage of 2.5 V, that is, which is determined as maximum analog input voltage Vr of A/D converter 101.

The reference voltage is so produced that an accurate output voltage of Zener diode 109 is divided by high accuracy resistor 110, such as a metal-film resistor. Varying the resistor values of accuracy resistors 110 allows each of the four reference voltages to have a different voltage value. Such obtained voltages are connected to an input terminal of multiplexer 106 for reference voltage. Although different four voltages are used in the embodiment, it is not limited thereto. When more than four reference voltages are used, further accurate error-correction is expected. Connecting a plurality of accuracy resistors 110 in series contributes to a simplified wiring. In this case, a voltage at the mid point between resistors 110 is given as each reference voltage.

In the structure of the embodiment, resistor 108 decreases an analog input voltage to 1/8 in magnitude; the structure can accept up to eight times maximum analog input voltage Vr, i.e., up to 20V (= 2.5V x 8) of analog input. Suppose that the voltage range around 5V (4V - 6V) needs highly accurate error-correction and the maximum voltage of analog input measures 12V. In this case, the four reference voltages may be determined, by adjusting the resistance value of accuracy resistors 110, to 0.5V, 0.625V, 0.75V and 1.5V, each of which corresponds to one-eighth of 4V, 5V, 6V and 12V of analog input. That is, the setting of the reference voltages may be concentrated around the analog-input range that needs highly accurate error-correction. Such a setting of the reference voltage provides further accurate error-correction concentrated on a selective range of analog input voltage.

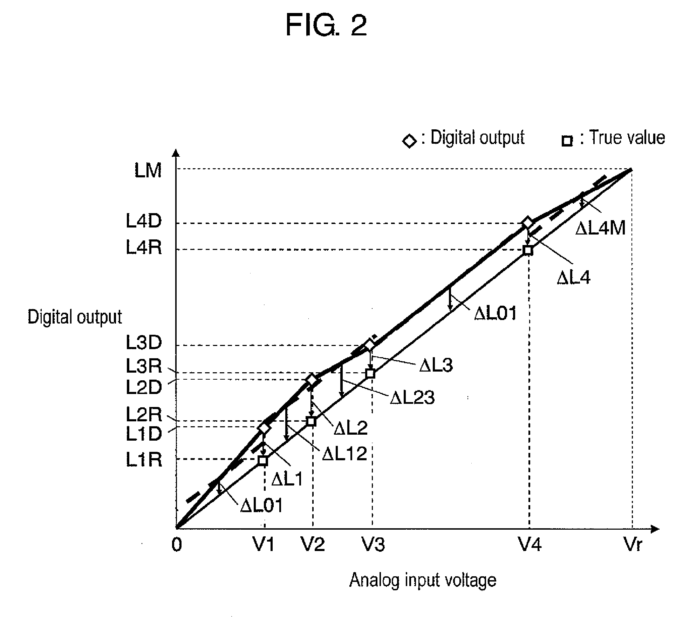

Next will be described the error-correction method of the A/D conversion apparatus having the structure above with reference to Fig. 2. Fig. 2 shows correlation between analog input voltage and digital output under the first correction state of the A/D conversion apparatus in accordance with the embodiment.

The description will be given on an example where maximum analog input voltage Vr (2.5V) from Zener diode 109 is fed into microcomputer 100. When analog voltage takes the ground level (i.e., 0V as the minimum value), A/D converter 101 outputs zero as the minimum digital output; on the other hand, when analog voltage takes the maximum value (i.e., voltage Vr), A/D converter 101 outputs voltage LM as the maximum digital output. As described earlier, microcomputer 100 has 10-bit A/D converter 101 with a resolution of 1024 (= 2¹⁰). That is, when analog voltage takes the ground level (i.e., 0V as the minimum value), A/D converter 101 outputs zero as the minimum digital output; on the other hand, when analog voltage takes the maximum value (i.e., 2.5V), A/D converter 101 outputs LM (= 1023) as the maximum digital output.

Fig. 2 shows analog input voltage on the horizontal axis and digital output on the vertical axis. In Fig. 2, true values corresponding to digital output of A/D converter 101 are distributed along the thin solid line connecting between the origin coordinates (0,0) and coordinates (Vr, LM) that represents maximum value LM at maximum analog input voltage Vr. That is, approximating the digital output from A/D converter 101 to the line of the true values contributes to obtaining digital output with high accuracy.

However, as described in Background Art, digital output fed from A/D converter 101 is not always found on the line that connects between the coordinates (0,0) and (Vr, VM) due to an error. The A/D conversion apparatus of the embodiment addresses the inconveniency and provides accurate digital output. Hereinafter will be described the workings of the A/D conversion apparatus with reference to Fig. 2.

It will be understood from the description above that the true values of digital output are found on the line (hereinafter, true-value line) connecting between the minimum output indicated by origin coordinates (0,0) and the maximum output indicated by coordinates (Vr, VM). Next, microcomputer 100 calculates, by controlling multiplexer 106 that serves as a selector, a plurality of digital outputs for each of reference voltages generated by accuracy resistors 110.

Specifically, microcomputer 100 requests multiplexer 106 to select reference voltage V1 (0.5V, for example). Reference voltage V1 as the output from multiplexer 106 is fed as analog input voltage into A/D converter 101 via input port 102b and selector switch 104.

As an ideal digital output corresponding to reference voltage V1, A/D converter 101 should provide true value L1R indicated by a squire point on the true-value line (Fig. 2); in reality, A/D converter 101 provides digital output L1D indicated by a diamond-shaped point away from the true-value line due to limitations in capability of the converter and an adverse effect from the peripheral circuits.

In the process above, microcomputer 100 recognizes that A/D converter 101 has received reference voltage V1 (0.5V) as the current analog input voltage. Therefore, calculator 100a subtracts true value L1R found on the true-value line from digital output L1D at reference voltage V1 (0.5V) to obtain error ΔL1. Such calculated error ΔL1 is stored in internal memory 100b.

After the calculation of error ΔL1, reference voltage V1 is sequentially switched by multiplexer 106 to voltages V2, V3 and V4. As for each reference voltage, calculator 100a calculates errors Δ L2, Δ L3 and Δ L4 and stores them into internal memory 100b. Fig. 2 shows an example where all of digital outputs of A/D converter 101 are greater than the true values corresponding to each output at all reference voltages between the minimum value (0V) and maximum analog input voltage Vr. Since calculator 100a obtains the errors ΔL1, ΔL2, ΔL3 and Δ L4 by subtracting the true value from digital output of A/D converter 101, all the errors are positive in sign.

Next will be described calculation of a reference error to be applied to any given analog input voltage. The reference error above represents an amount of error-correction on digital output of A/D converter 101 corresponding to any given analog input voltage.

As described above, calculator 100a has obtained the errors at four voltages (V1, V2, V3 and V4) between 0V and maximum analog input voltage Vr. Therefore, determining a reference error so as to be applied to a voltage range, such as the range between V1 and V2, the range between V2 and V3, provides error correction with higher accuracy.

However, any given analog input voltage Vx is an unknown quantity because it is not a reference voltage. Therefore, even if calculating a reference error for a voltage range divided between reference voltages V1 and V4 so as to be applied to any given analog input voltage Vx, the A/D conversion apparatus cannot carry out error correction because no way to find the range to which any given analog input voltage Vx belongs. This is the reason why the method of patent reference 1 has employed the error correction where error ΔD is uniformly subtracted from digital output regardless of the magnitude of analog input voltage.

To address the inconveniency, the method of the embodiment carries out error correction in a manner that, instead of analog input voltage, digital output ranging from 0(V) to maximum value LM is divided into several sections. Specifically, digital output of A/D converter 101 is divided into sections bordered with digital outputs L1D, L2D, L3D and L4D at reference voltages V1, V2, V3 and V4, respectively. Digital outputs L1D through L4D are stored in internal memory 100b. Fig. 2 shows an example where digital output is divided into five output-ranges: range [0 - L1D]; range [L1D - L2D]; range [L2D - L3D]; range [L3D - L4D]; and range [L4D - LM]. The reference error applied to each range is determined in advance by the method that will be described later.

In this way, prior to error correction, the apparatus of the embodiment judges which range (out of the five output-ranges above) contains digital output LxD fed from A/D converter 101 corresponding to any given analog input voltage Vx. After that, with the use of the reference error to be applied to the range, the apparatus carries out error correction.

Next will be described how to determine the reference error. As described above, calculator 100a has obtained the errors ΔL1, Δ L2, Δ L3 and Δ L4 at reference voltages V1, V2, V3, and V4, respectively. A reference error is basically―with an exception below―calculated as an average of the errors of adjacent output-ranges. If the errors of adjacent two output-ranges are opposite in sign, the reference error takes zero (that will be described later).

Besides, each error at 0V and maximum value LM is determined zero; range [0 - L1D] and range [L4D - LM] take the reference error with half amount of error ΔL1, ΔL4, respectively.

According to the example shown in Fig. 2, all the errors are positive in sign; the errors of adjacent two output-ranges have same signs. That is, the reference error is calculated as the average of the errors of adjacent two output-ranges. In this case, the reference errors applied to the five output-ranges are calculated as follows:
1) range [0 - L1D]: reference error ΔL01 = (0 + ΔL1) / 2;
2) range [L1D - L2D]: reference error ΔL12 = (ΔL1 + ΔL2) / 2;
3) range [L2D - L3D]: reference error ΔL23 = (ΔL2 + ΔL3) / 2;
4) range [L3D - L4D]: reference error ΔL34 = (ΔL3 + ΔL4) / 2; and
5) range [L4D - LM] : reference error ΔL4M = (ΔL4 + 0) / 2.

Therefore, a reference error is determined by judging digital output LxD corresponding to any given analog input voltage belongs to which range in the five above. The thick dot line in Fig. 2 shows the graph in which the reference error of each range is added on true values.

According to the conventional method introduced in patent reference 1, error ΔD is uniformly applied to all the ranges. In contrast, the method of the embodiment selectively uses a reference error according to the five output-ranges, enhancing accuracy of error correction. When digital output LxD corresponding to any given analog input voltage equals to any one of digital outputs L1D, L2D, L3D and L4D (obtained at reference voltages V1, V2, V3 and V4, respectively), respective one of errors ΔL1, ΔL2, ΔL3 and ΔL4 (as already calculated values) is subtracted from the digital output to obtain a corrected digital output. Through the calculations above, the A/D conversion apparatus determines the reference error applied to each output-range.

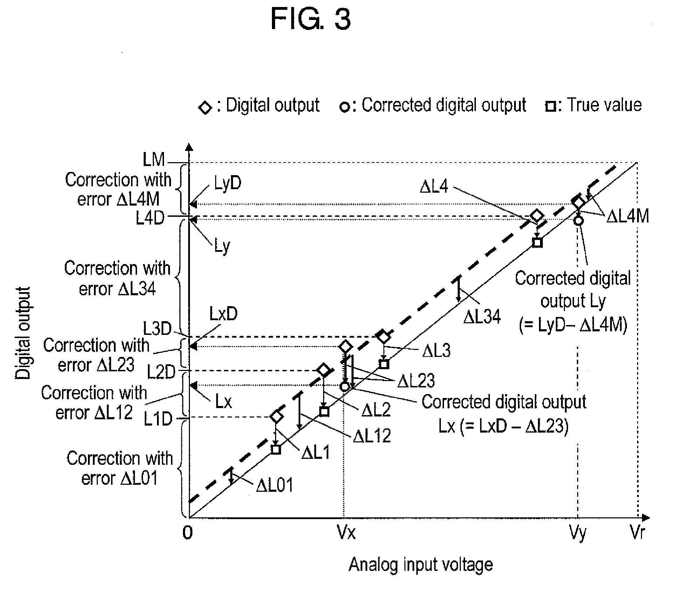

Next will be specifically described the error correction with reference to Fig. 3. Fig. 3 shows correlation between analog input voltage and digital output in a correction example under the first correction state of the A/D conversion apparatus in accordance with the first exemplary embodiment.

Now suppose that analog input voltage Vx (as divided voltage by resistor 108) is fed into A/D converter 101 via multiplexer 105 for analog input voltage, input port 102a and selector switch 104. As shown in Fig. 3, digital output LxD from A/D converter 101 (indicated by a diamond-shaped point) belongs to range [L2D - L3D], and therefore, digital output LxD undergoes error correction with the use of reference error ΔL23; calculator 100a calculates corrected digital output Lx by subtracting error ΔL23 from digital output LxD: Lx = LxD - ΔL23. As is apparent from Fig. 3, corrected digital output Lx indicated by a round point is positioned very close to the true-value line, compared to digital output LxD before correction. Digital output LxD thus undergoes error correction with high accuracy.

Now suppose that analog input voltage Vy (as another input selected by multiplexer 105) is fed into A/D converter 101. Digital output LyD corresponding to voltage Vy, as is indicated by a diamond-shaped point in Fig. 3, belongs to range [L4D - LM], and therefore, digital output LyD undergoes error correction with the use of reference error ΔL4M; calculator 100a calculates corrected digital output Ly by the calculation below: Ly = LyD - ΔL4M.

Corrected digital output Ly is indicated by a round point in Fig. 3. Digital output LyD has less deviation from the thick solid line (indicating output characteristics of A/D converter 101) of Fig. 2; digital output LyD at around voltage Vy is positioned close to the true-value line. Besides, at around analog input voltage Vy, the thick solid line (Fig. 2) is close to the true-value line, that is, reference error ΔL4M has a small value. As a result, corrected digital output Ly is positioned close to the true-value line, as well as digital output LyD.

According to the error-correction method of the first embodiment, a small reference error is given to the output-range where a digital output before correction is positioned close to the true-value line, while a large reference error is given to the output-range where a digital output before correction is away from the true-value line. In the conventional method employing fixed error ΔD, as is seen in the case of the correction on digital output V5Da in Fig. 15, accurate correction is not always expected; on the contrary, gets worse in some cases. In contrast, the method of the embodiment provides proper digital output corresponding to analog input voltage, enhancing accuracy of the error correction.

The description so far has been given on a case where all of errors ΔL1, ΔL2, ΔL3 and ΔL4 at reference voltages V1, V2, V3 and V4, respectively, have positive signs, i.e., in a case where digital output of A/D converter 101 has characteristics with a positive shift from the true-value line. In a case of characteristics with a negative shift (where, all of errors ΔL1, ΔL2, ΔL3 and ΔL4 have negative signs), too, the method of the embodiment provides accurate error correction in a similar way.

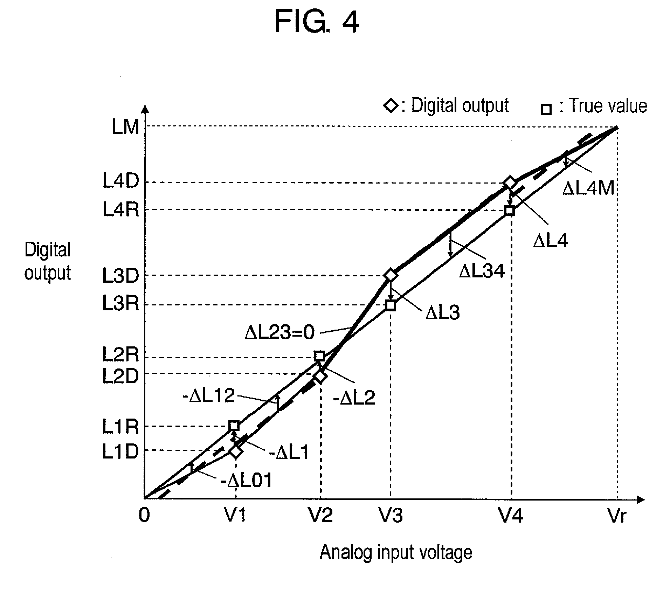

In a real-world situation, however, digital output of A/D converter 101 is affected by not only the characteristics of the A/D converter but also noise and other adversely effects caused by a peripheral circuit. In such a case, digital output can shift in both direction of positive and negative with respect to the true-value line. Here will be described error correction on this case with reference to Fig. 4 through Fig. 7.

Fig. 4 shows correlation between analog input voltage and digital output under the second correction state of the A/D conversion apparatus in accordance with the first exemplary embodiment. Like in Fig. 2, Fig. 4 shows analog input voltage on the horizontal axis and digital output on the vertical axis. The graph of Fig. 4 differs from that of Fig. 2 in that digital outputs L1D and L2D (indicated by diamond-shaped points) at reference voltage V1 and V2, respectively, are smaller than true values L1R and L2R (indicated by square points) on the true-value line.

In this case, the reference errors applied to the five output-ranges are calculated as follows:
1) range [0 - L1D]: reference error - ΔL01 (0 - ΔL1) / 2;
2) range [L1D - L2D]: reference error - ΔL12 = (- ΔL1 - ΔL2) / 2;
3) range [L2D - L3D]: reference error ΔL23 = 0;
4) range [L3D - L4D]: reference error ΔL34 = (ΔL3 + ΔL4) / 2; and
5) range [L4D - LM]: reference error ΔL4M = (ΔL4 + 0) / 2.

In the calculation above, it should be noted at 3) where digital output changes from the lower side to the upper side of the true-value line. It is hard to know the cause of the changes (i.e., may be caused by characteristics of the A/D converter, or may be caused by other effects such as noise). If the reference error is calculated as an average of adjacent two ranges, i.e., calculated by the expression: (- ΔL2 + ΔL3) / 2, and is applied to the error correction, it may increase a risk; if noise or other factors affects the changes, the error correction can degrade the accuracy of a corrected digital output. To avoid the risk, a digital output in the range (where the errors of adjacent ranges have different signs) has no error-correction. From the reason, reference error ΔL23 (= 0) is applied to range [L2D - L3D].

Like in Fig. 2, the thick dot line in Fig. 4 shows the graph in which the reference error of each range is added on true values. As described above, range [L2D - L3D] has no error-correction. Since the digital output obtained from A/D converter 101 is regarded as the corrected digital output, range [L2D - L3D] has no thick dot line.

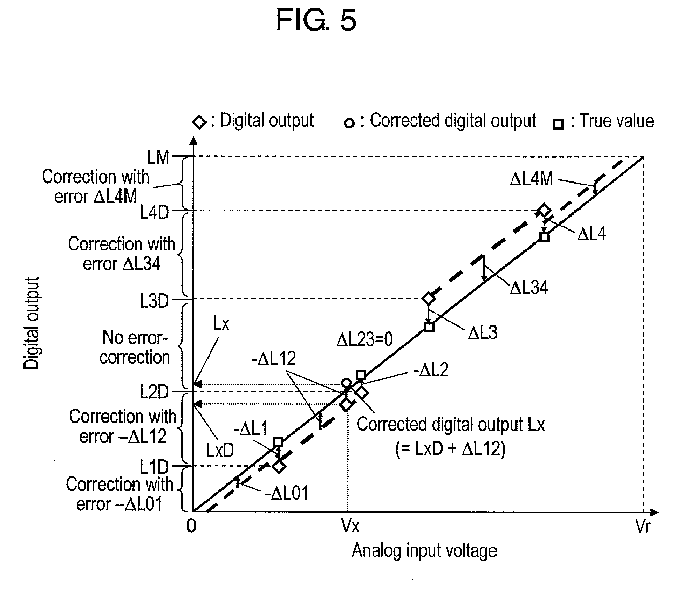

Next will be specifically described how to determine corrected digital output corresponding to any given analog input voltage in the example of Fig. 4 with reference to Fig. 5. Fig. 5 shows correlation between analog input voltage and digital output in a correction example under the second correction state of the A/D conversion apparatus of the embodiment. Like in Fig. 4, Fig. 5 shows analog input voltage on the horizontal axis and digital output on the vertical axis.

Now suppose that analog input voltage Vx (with the same magnitude as voltage Vx in Fig. 3) is fed into A/D converter 101. As shown in Fig. 5, digital output LxD (indicated by a diamond-shaped point) belongs to range [L1D - L2D], and therefore, digital output LxD undergoes error correction with the use of reference error ― ΔL12; calculator 100a calculates corrected digital output Lx by the expression: Lx = LxD + ΔL12. As is apparent from Fig. 5, corrected digital output Lx (indicated by a round point) is positioned very close to the true-value line, compared to digital output LxD before correction. Digital output LxD thus undergoes error correction with high accuracy.

It will be understood that the apparatus provides highly accurate error-correction even when the digital output of A/D converter 101 has a shift downward from the true-value line.

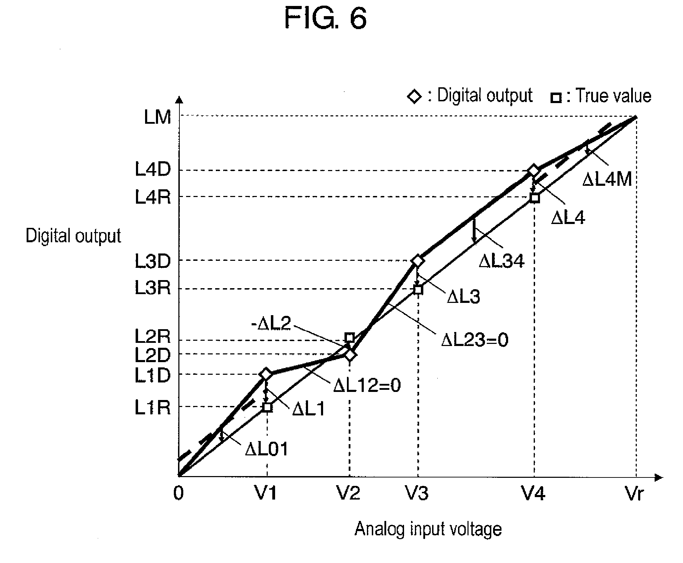

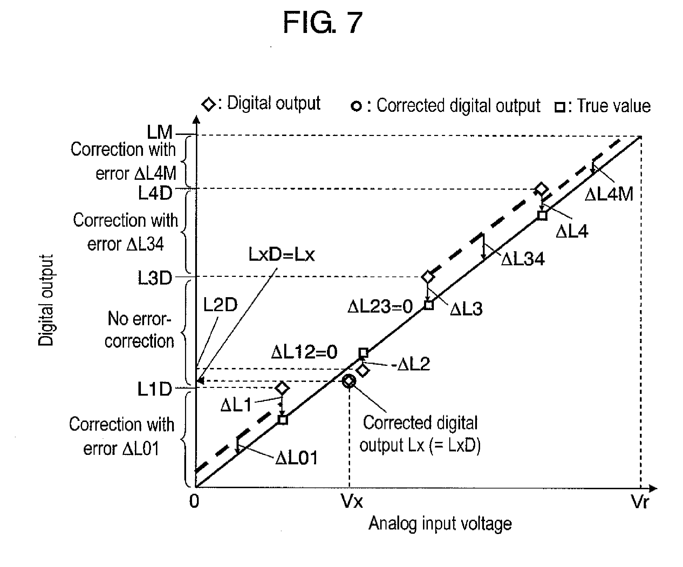

Next will be described an example where no error-correction is provided, with reference to Fig. 6 and Fig. 7. Fig. 6 shows correlation between analog input voltage and digital output under the third correction state of the A/D conversion apparatus in accordance with the embodiment. Like in Fig. 2, Fig. 6 shows analog input voltage on the horizontal axis and digital output on the vertical axis. The graph of Fig. 6 differs from that of Fig. 2 in that only digital output L2D (indicated by a diamond-shaped point) at reference voltage V2 is smaller than true value L2R (indicated by a square point) on the true-value line.

In this case, the reference errors applied to five output-ranges are calculated as follows:
1) range [0 - L1D]: reference error ΔL01 = (0 + ΔL1) /2;
2) range [L1D - L2D]: reference error ΔL12 = 0;
3) range [L2D - L3D]: reference error ΔL23 = 0;
4) range [L3D - L4D]: reference error ΔL34 = (ΔL3 + ΔL4) / 2; and
5) range [L4D - LM]: reference error ΔL4M = (ΔL4 + 0) / 2.

In the calculation above, it should be noted at 2) and 3) where digital output L2D at reference voltage V2 is smaller than true value L2R; and accordingly, the sign of the errors alternately changes in the two ranges. In this case, too, it is hard to know the cause of the changes (i.e., may be caused by characteristics of the A/D converter, or may be caused by other effects such as noise). From the same reason described in Fig. 4 and Fig. 5, digital output in the two ranges has no error-correction. That is, reference errors ΔL12 and ΔL23 take zero (0). When any given analog input voltage equals to reference voltage V2, that is, digital output L2D undergoes error correction with error -ΔL2.

Like in Fig. 4, the thick dot line in Fig. 6 shows the graph in which the reference error of each range is added on true values. As described above, ranges [L1D - L2D] and [L2D - L3D] have no error-correction. Since the digital output obtained from A/D converter 101 within the ranges is regarded as the corrected digital output, the consecutive two ranges have no thick dot line.

Next will be specifically described how to determine corrected digital output corresponding to any given analog input voltage in the example of Fig. 6 with reference to Fig. 7. Fig. 7 shows correlation between analog input voltage and digital output in a correction example under the third correction state of the A/D conversion apparatus of the embodiment. Like in Fig. 6, Fig. 7 shows analog input voltage on the horizontal axis and digital output on the vertical axis.

Now suppose that analog input voltage Vx (with the same magnitude as voltage Vx in Fig. 3) is fed into A/D converter 101. As shown in Fig. 7, digital output LxD (indicated by a diamond-shaped point) belongs to range [L1D - L2D], and therefore, digital output LxD undergoes no error-correction, since reference error ΔL12 takes zero in the range; digital LxD fed from A/D converter 101 equals to corrected digital output Lx in this case. In Fig. 7, the round point (indicating corrected digital output Lx) and the diamond-shaped point (indicating digital output LxD) take the same position. It will be understood that no error-correction is needed because digital output LxD is close to the true-value line in the first place.

As described above, error correction is not always needed, in particular, in a case where the errors in adjacent two-ranges have different signs due to unstable analog input voltage. The apparatus of the present invention decreases the risk of accuracy degradation by unnecessary error-correction.

The A/D conversion apparatus of the present invention has A/D converter 101 for converting analog input voltage into digital output; a reference-voltage source connected to A/D converter 101 via a selector; and microcomputer 100 that has a connection to the selector and calculates corrected digital output from the digital output fed from A/D converter 101. Microcomputer 100a has following steps in the calculation:
- calculating a plurality of digital outputs at a plurality of reference voltages fed from the reference-voltage source while switching the selector; and
- determining each error used for error correction in a manner that previously obtained true values corresponding to the plurality of digital output are subtracted from the digital outputs.

The error-determining step above has further a reference-error calculating step. The reference error is applied to a digital-output range that is divided by the digital outputs corresponding to the reference voltages. In the reference-error calculating step, the reference error is determined differently according to the following condition:
- when the errors obtained at adjacent reference voltages have same signs, the reference error is determined as an average of the errors obtained at adjacent reference voltages; and
- when the errors obtained at adjacent reference voltages have different signs, the reference error is determined to be zero.

After that, microcomputer 100 carries out error correction in a manner that a corrected digital output is calculated by subtracting the reference error (which is applied to the digital-output range including the digital output) from the digital output corresponding to analog input voltage, and then outputs the corrected digital output.

With the structure and the error-correction steps above, the A/D conversion apparatus determines corrected digital output. Compared to the conventional method with the use of fixed error ΔD alone, the method of the present invention with the use of more-than-one reference errors enhances accuracy and reliability of error correction. Besides, the apparatus of the present invention decreases the risk of accuracy degradation by unnecessary error-correction; when the errors at adjacent reference voltages have different signs, the reference error takes zero (i.e., no error-correction is provided).

### (SECOND EXEMPLARY EMBODIMENT)

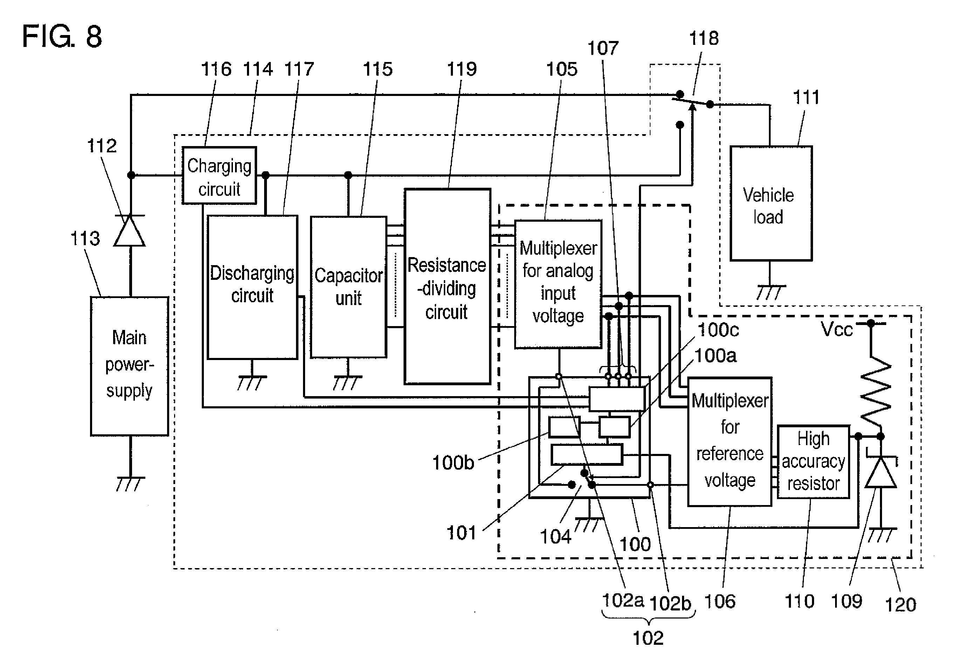

Fig. 8 is a circuit block diagram of a vehicle power-supply device using the A/D conversion apparatus in accordance with the second exemplary embodiment of the present invention. In Fig. 8, like parts are identified by the same reference marks as in Fig. 1 and the description thereof will be omitted. In Fig. 8, vehicle load 111 responsible for the braking system of the vehicle is connected to main power-supply 113 (battery) via power switch 112 formed of a diode. Main power-supply 113 usually supplies electric power to vehicle load 111. Power switch 112 prevents unwanted current-flow into main power-supply 113.

Vehicle load 111 has a voltage stabilizing circuit (not shown); in case that main power-supply 113 cannot drive vehicle load 111 due to excessively low voltage below a predetermined voltage (for example, below 9.5V), power-supply backup unit 114 is connected to main power-supply 113. Power-supply backup unit 114 (surrounded by the thin dot line in Fig. 8) is an auxiliary power-supply device for supplying power to vehicle load 111 in case of emergency.

Here will be given in-detail description on power-supply backup unit 114. Power-supply backup unit 114 has capacitor unit 115 having a plurality of capacitors as an emergency power supply. If main power-supply 113 gets into an abnormal condition, capacitor unit 115 feeds power to vehicle load 111. Capacitor unit 115 is connected to charging circuit 116 and discharging circuit 117. Upon startup of driving the vehicle, charging circuit 116 charges capacitor unit 115, and on the completion of the driving, discharging circuit 117 discharges capacitor unit 115. Capacitor unit 115 is kept in discharged condition during non-use periods of the vehicle, which increases the operating life of the capacitor.

The output from capacitor unit 115 is connected to power-supply selector switch 118. Selector switch 118 is a two-way switch; one of which is connected to capacitor unit 115, and the other is connected to main power-supply 113; and the common terminal of selector switch 118 is connected to vehicle load 111. With the structure above, selector switch 118 switches between main power-supply 113 and capacitor unit 115 to feed power to vehicle load 111. Power-supply selector switch 118 is formed of a structure that is selectable by an external signal, such as a relay.

Capacitor unit 115 needs voltage detection to monitor the operating condition of capacitors. In Fig. 8, A/D conversion apparatus 120 (surrounded by the thick solid line) of the first embodiment is connected, via resistance-dividing circuit 119, to signal lines for carrying voltage-output of the capacitors. With the structure above, A/D conversion apparatus 120 receives voltage of the capacitors. A/D conversion apparatus 120 employed here has the same structure as that described in the first embodiment.

In the structure of the second embodiment, microcomputer 100 of A/D conversion apparatus 120 has a built-in controller for power-supply backup unit 114. Microcomputer 100 has electrical connections with signal lines for communicating data with charging circuit 116, discharging circuit 117 and selector switch 118 so that the controller in the microcomputer controls charging circuit 116, recharging circuit 117 and selector switch 118.

Next will be described the workings of the vehicle power-supply device with the structure above. Upon startup of driving the vehicle, microcomputer 100 switches selector switch 118 to the side of main power-supply 113 so that power is supplied from main power-supply 113 to vehicle load 111, and at the same time, transmits to charging circuit 116 a control signal for charging capacitor unit 115. Receiving the control signal, charging circuit 116 charges capacitor unit 115 to full charge. Full charging requires few minutes; in the meantime, microcomputer 100, with the use of Zener diode 109 and high accuracy resistor 110, receives reference voltages from multiplexer 106 to obtain reference errors for the digital-output ranges, as described in the first embodiment. The calculated reference errors are stored in internal memory 100b.

The wiring shown in the circuit block diagram of Fig. 8 allows the selection signal fed from selector port 107 to simultaneously switch multiplexer 105 (for analog input voltage) and multiplexer 106 (for reference voltage). This is because of no correlation between outputs of multiplexer 105 and multiplexer 106. The shared use of selector port 107, as shown in Fig. 8, contributes to a simplified wiring.

On the completion of the reference-error calculation in the charging process, microcomputer 100 stops the charging and calculates an internal resistance value of capacitor unit 115 at the voltage obtained at that moment and also calculates an internal capacity value from rate of change in voltage per unit time during the charging process. Microcomputer 100 compares the calculated current internal resistance value with a predetermined threshold value of the internal resistance value to the calculated current internal capacity value. The comparison above allows microcomputer 100 to judge degradation in quality (i.e., the operating life) of capacitor unit 115.

In the process above, employing the A/D conversion apparatus of the first embodiment to detect voltage enhances measurement accuracy of the internal resistance value and the internal capacity value of capacitor unit 115. By virtue of the improved accuracy, the operating life of capacitor unit 115 is extended to almost its limitation, compared to a conventional structure where the judgment on degradation has been carried out sufficiently ahead of time.

After the judgment process, microcomputer 100 checks each capacitor of capacitor unit 115 for an overcharge condition. In the process, first, voltage of each capacitor is fed, via resistance-dividing circuit 119, into multiplexer 105 (for analog input voltage) in A/D conversion apparatus 120. As described in the first embodiment, resistance-dividing circuit 119 reduces the voltage of the capacitor to 1/8 so that A/D converter 101 built in microcomputer 100 can handle it.

As microcomputer 100 selects the capacitors one after another, the voltage of the selected capacitor is fed into A/D converter 101 via input port 102a and selector switch 104 built in microcomputer 100.

A/D converter 101 sends to calculator 100a digital output corresponding to analog input voltage. Receiving the digital output, calculator 100a carries out the error correction described in the first embodiment to obtain corrected digital output. According to the value of the corrected digital output, microcomputer 100 checks each capacitor for an overcharge condition.

A/D conversion apparatus thus offers voltage of each capacitor with high accuracy, providing reliable charging operations with overcharging minimized.

Power-supply backup unit 114 remains a stand-by mode unless main power-supply 113 falls into an abnormal condition. During the stand-by mode, microcomputer 100 detects voltage of the capacitors of capacitor unit 115 to know the condition of each capacitor. If capacitor unit 115 has an overcharged voltage, microcomputer 100 effects control of charging circuit 116 and discharging circuit 117 to provide capacitor unit 115 with proper voltage. The voltage detection by A/D conversion apparatus of the first embodiment enhances reliability of the charging control against overcharging.

If charging circuit 116 detects that main power-supply 113 has a voltage-drop below a predetermined voltage (of 9.5V) due to breakdown of itself or damages in peripheral wiring, microcomputer 100 sets selector switch 118 on the side of capacitor unit 115 so that power is supplied to vehicle load 111. This allows the breaking system to stop the vehicle with safety even if main power-supply 113 has abnormalities.

The reference errors are calculated not only at startup of the vehicle but also at a predetermined period during which multiplexer 105 is not used in driving. The regular check during driving allows microcomputer 100 to correct the reference errors even if a drift occurs in the reference errors caused by noise in driving, for example. This increases correction accuracy; accordingly, improves reliability of the vehicle power-supply device.

As described above, employing the A/D conversion apparatus of the first embodiment allows the vehicle power-supply device to have highly accurate voltage detection of capacitor unit 115 as an auxiliary power-supply, thereby providing an improved check for overcharge and operating life of capacitor unit 115. Such advantages significantly enhance reliability of the vehicle power-supply device.

### (THIRD EXEMPLARY EMBODIMENT)

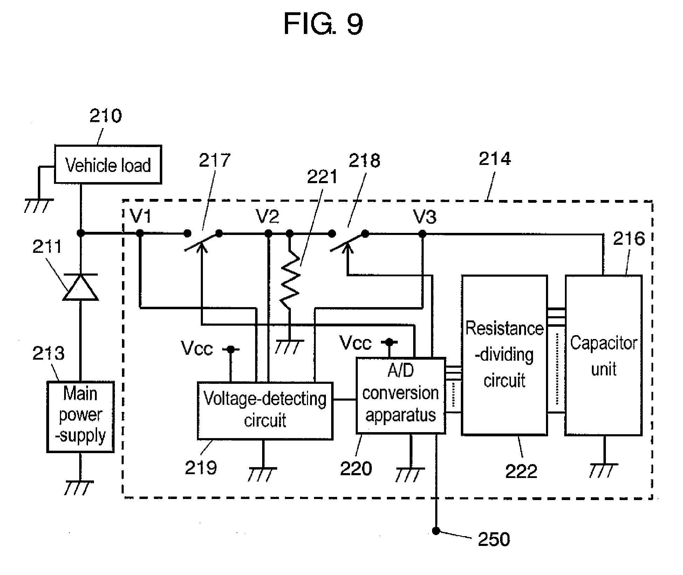

Fig. 9 is a circuit block diagram of a vehicle power-supply device using the A/D conversion apparatus in accordance with the third exemplary embodiment of the present invention. In Fig. 9, vehicle load 210 responsible for the braking system of the vehicle is connected to main power-supply 213 (battery) via power switch 211 formed of a diode. Vehicle load 210 is connected to power-supply backup unit 214 in case that main power-supply 213 cannot drive vehicle load 210 due to an excessively low voltage below a predetermined voltage. Power-supply backup unit 214 (surrounded by the dot line in Fig. 9) is an auxiliary power-supply device for supplying power to vehicle load 210 in case of emergency.

Here will be given in-detail description on power-supply backup unit 214. Power-supply backup unit 214 has capacitor unit 216 as an emergency power supply having a plurality of electrical double-layer capacitors.

Between vehicle load 210 and capacitor unit 216, first switch 217 and second switch 218 are connected in series, in the order named, to vehicle load 210. First switch 217 and second switch 218 are relays controllable by an external signal. Instead of a diode, the structure of the embodiment uses a relay with little voltage-drop when it turns on. Therefore, there is no need to allow for the voltage-drop of a diode; capacitor unit 216 has no need to have a plurality of capacitors.

In the structure, voltage-detecting circuit 219 measures voltage V1 between vehicle load 210 and first switch 217; voltage V2 between first switch 217 and second switch 218; and voltage V3 between second switch 218 and capacitor unit 216. Switching one after another, voltage-detecting circuit 219 carries out the measurement of V1 through V3.

A/D conversion apparatus 220 effects on/off-control of first switch 217 and second switch 218. The voltage measured by voltage-detecting circuit 219 is fed into A/D conversion apparatus 220.

A/D conversion apparatus 220 is connected to the vehicle-control CPU (not shown). Input/output terminal 250 in Fig. 9 is for exchanging signals between them.

Discharging circuit 221 with a high resistance value of a few kilo ohms is connected between first switch 217 and second switch 218. The other end of discharging circuit 221 is connected to the ground. Therefore, when both of first switch 217 and second switch 218 turn off, voltage V2 equals to the ground level. In the embodiment, the ground level is employed for a predetermined value of voltage V2 and is used as the criterion for judging a short-circuit failure; there is no short-circuit as long as voltage V2 equals to the ground level―detailed description thereof will be given later. Although the ground level is used in the embodiment, the predetermined value of V2 may take any given value. In that case, there is no short-circuit failure when voltage V2 does not exceed the value.

Like in the structure of the second embodiment, resistance-dividing circuit 222 is connected between capacitor unit 216 and A/D conversion apparatus 220. The structure provides highly accurate voltage-detection of capacitor unit 216, enhancing reliability of the vehicle power-supply device.

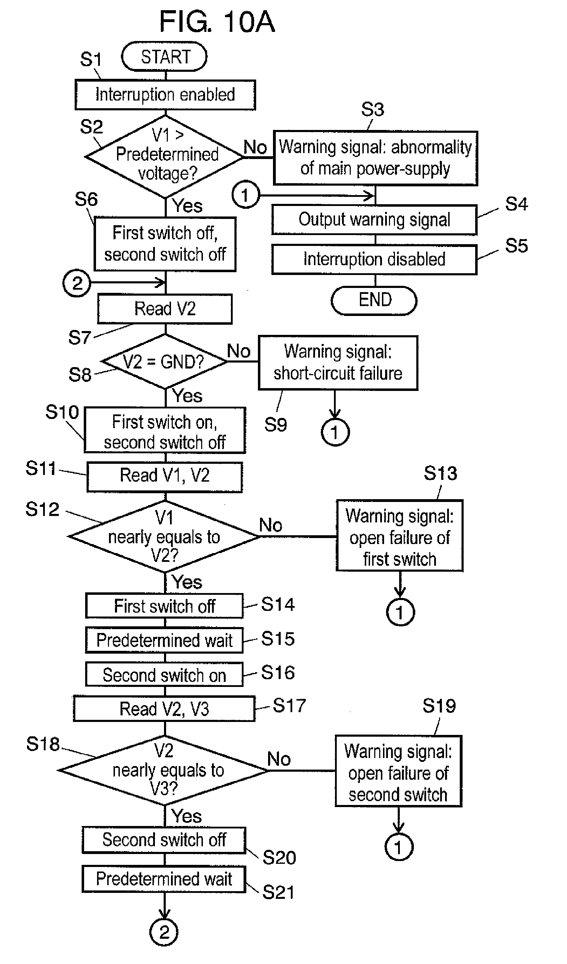

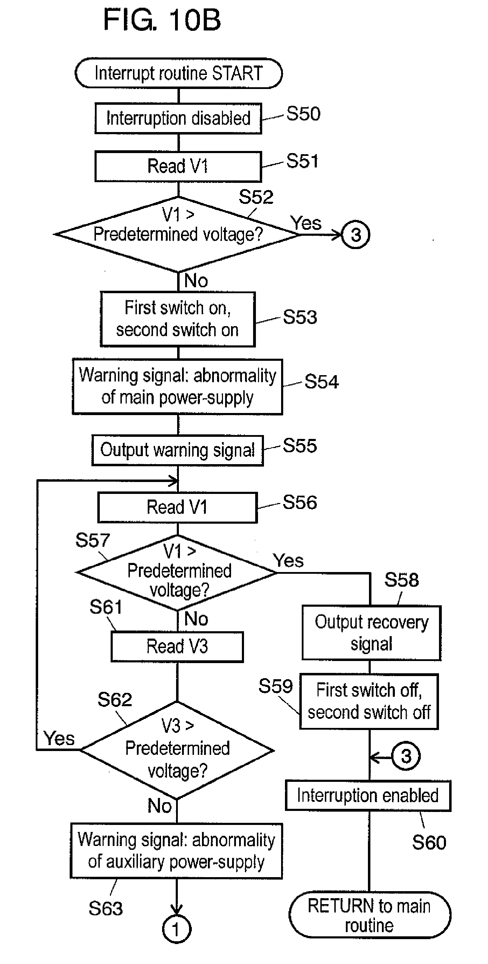

Incorporating an advantage of the structure of the embodiment with the workings described in the second embodiment provides the vehicle power-supply device with higher reliability. The noticeable workings will be described hereinafter with reference to Fig. 10A and Fig. 10B. Figs. 10A and 10B are flow charts illustrating the workings of the vehicle power-supply device using the A/D conversion apparatus in accordance with the third exemplary embodiment of the present invention. Specifically, Fig. 10A shows the main routine of the fault diagnosis program that is preinstalled in A/D conversion apparatus 220. Fig. 10B shows an interrupt routine that is interruptedly carried out at regular intervals.

First, the main routine will be described. On startup of a vehicle, capacitor unit 216 is charged by a circuit (not shown in Fig. 9) connected to main power-supply 213. On completion of the charge, the main routine of Fig. 10A starts, with first switch 217 and second switch 218 (Fig. 9) kept off.

In step S1, interruption call (for carrying out the interrupt routine) is set into an enabled mode. From here on, the interrupt routine is interruptedly carried out at regular intervals in the process of the main routine. The detailed description thereof will be given later.

In step S2, voltage V1 received from voltage-detecting circuit 219 is compared to a predetermined voltage. The predetermined voltage is the minimum voltage capable of driving vehicle load 210. If voltage V1 (that corresponds to the voltage of main power-supply 213) is lower than the predetermined voltage, the flow of the process goes to "No" at S2. In this case, the system generates a warning signal indicating abnormality of main power-supply 213 (in step S3) and sends the signal to the vehicle control CPU (in step S4). Receiving the signal, the vehicle control CPU issues an alarm indicating that the vehicle is in need of repair. In this case, the vehicle is out of control due to the abnormal condition of main power-supply 213; power-supply backup unit 214 has no need for supplying power to vehicle load 210. After the warning-signal output, there is no need to continue the interrupt routine. The system sets interruption call into a disabled mode (in step S5) and exits the main routine.

On the other hand, if voltage V1 is larger than the predetermined voltage (i.e., "Yes" at S2), the system judges that main power-supply 213 is in normal condition and carries out fault-diagnosis operation on first switch 217 and second switch 218.

In step S6, both the switches are turned off. In step S7, voltage-detecting circuit 219 detects voltage V2 and transmits it to A/D conversion apparatus 220. The circuit section carrying voltage V2 is connected to the ground via discharging circuit 221; when both of first switch 217 and second switch 218 are off, electric charge of the circuit section is discharged to the ground by discharging circuit 221. That is, voltage V2 equals to the ground level as the predetermined value defined in the third embodiment.

In step S8, the system judges whether voltage V2 equals to the ground level (GND). If voltage V2 does not equal to GND, the flow of the process goes to "No" at S8. In this case, other voltages (V2 and/or V3) are applied to the circuit section because that first switch 217 and/or second switch 218 has a short-circuit failure (i.e., at least one of them keeps on). The system generates a warning signal indicating short-circuit failure (in step S9) and the flow of the process goes to step S4 to output the signal.

The judgment in step S8 only tells the fact that a short-circuit failure has occurred and does not tell which one (or both) of the switches have the short-circuit failure from the following intentional reasons.
- it is important to notify the driver the failure before narrowing down the exact place where it has occurred;
- replacing both of first switch 217 and second switch 218 with new ones enhances not only the efficiency of the repair work but also reliability of the switches.

On the other hand, if voltage V2 equals to GND (i.e., "Yes" at S8), the system turns on first switch 217 and turns off second switch 218 in step S10. Unlike a diode, first switch 217 has no voltage drop. Voltage V1 corresponding to the voltage of main power-supply 213 nearly equals to voltage V2. Since second switch 218 remains off, voltage V2 has no influence on voltage V3 on the side of capacitor unit 216.

Discharging circuit 221, which is disposed at a circuit section carrying voltage V2, is a resistor having a high resistance value. Passing through extremely small amount of current, discharging circuit 221 reduces excessive current consumption.

In step 11, under the state where first switch 217 is on and second switch 218 is off, voltage-detecting circuit 219 detects voltages V1 and V2 across first switch 217 and transmits them to A/D conversion apparatus 220.

In the step S12, voltage V1 is compared to voltage V2. If they are almost the same, the system judges that first switch 217 functions normally. In this case, "Yes" is taken at step S12 and the flow of the process goes to step 14 where first switch 217 is turned off. If there is a difference between voltage V1 and voltage V2, "No" is taken at step 12. In this case, the system judges that an open failure has occurred because first switch 217 is not kept on for any reason. The system generates a warning signal indicating open failure of first switch 217 (in step S13) and the flow of the process goes to step S4 to output the signal.

In step 15, the system waits for a predetermined period (of 0.1 seconds in the third embodiment); in the meantime, discharge circuit 221 discharges the electric charges at the circuit section carrying voltage V2 to the ground.

In step S16, the system turns on second switch 218. Unlike a diode, second switch 218 has no voltage drop. Voltage V3 corresponding to the voltage of capacitor unit 216 nearly equals to voltage V2. Since first switch 217 remains off, voltage V2 has no influence on the side of main power-supply 213.

In step 17, under the state where first switch 217 is off and second switch 218 is on, voltage-detecting circuit 219 detects voltages V2 and V3 across second switch 218 and transmits them to A/D conversion apparatus 220.

In the step S18, voltage V2 is compared to voltage V3. If they are almost the same, the system judges that second switch 218 functions normally. In this case, "Yes" is taken at step S18 and the flow of the process goes to step 20 where second switch 218 is turned off. That is, both the switches are off in step 20. On the other hand, if there is a difference between voltage V2 and voltage V3, "No" is taken at step 18. In this case, the system judges that an open failure has occurred because second switch 218 is not kept on for any reason. The system generates a warning signal indicating open failure of second switch 218 (in step S19) and the flow of the process goes to step S4 to output the signal.

In the process, the fault diagnosis operation is carried out at predetermined intervals (for example, every 10 minutes); there is no need for carrying it out frequently in a short period. In step S21, the system waits for the predetermined period. In step S16, voltage V2 nearly equals to voltage V3. Second switch 218 turns off (in step 20) and the system has a predetermined wait (in step 21); in the meantime, discharging circuit 221 discharges electric charges, so that voltage V2 equals to the ground level.

On expiry of the predetermined wait, the flow of the process goes back to step S7 and the fault diagnosis operation on the two switches is repeatedly carried out. In this way, the fault diagnosis operation is carried out at regular intervals under operating conditions of power-supply backup unit 214. This increases reliability of power-supply backup unit 214.

Next will be described the interrupt routine carried out at regular intervals in the process of the main routine, with reference to Fig. 10B.

By virtue of interrupting operations of the interrupt routine, power supply can be quickly switched to capacitor unit 216 whenever an abnormal condition occurs in main power-supply 213. With the process carried out "independent" from the main routine, the interrupt routine effectively works in detecting abnormal conditions in main power-supply 213 and taking proper measures in an emergency. In the program installed in A/D conversion apparatus 220, an interrupt-call signal is issued every predetermined time (for example, a fraction of a second) measured by A/D conversion apparatus 220. Upon the output of the interrupt-call signal, the flow of the process unconditionally jumps to the interrupt routine from anywhere in the main routine where interruption call is enabled.

Upon jumping to the interrupt routine, the system sets interruption call to the disabled mode in step S50. In step S51, voltage-detecting circuit 219 detects voltage V1 corresponding to the voltage of main power-supply 213 and transmits it to A/D conversion apparatus 220.

In step S52, voltage V1 is compared to the predetermined voltage of main power-supply 213. If voltage V1 is greater than the predetermined voltage, the flow of the process goes to "Yes" at S52. In this case, the system judges that main power-supply 213 functions normally; the flow of the process jumps to step 60-where interruption call is set to the enabled mode-and exits the interrupt routine. In the main routine, the process is resumed from a step interrupted by the interruption call signal. On the other hand, if voltage V1 is lower than the predetermined voltage, "No" is taken at S52. In this case, the system judges that an abnormal condition has occurred in main power-supply 213. The system turns on first switch 217 and second switch 218 (in step S53), generates a warning signal indicating abnormality of main power-supply 213 (in step S54) and outputs the signal (in step S55).

In the process above, the system judges that first switch 217 and second switch 218 function normally. If an abnormal condition occurred, the system would not carry out step S53 because of interruption call is disabled at step S5. That is, carrying out step S53 guarantees that the two switches have no failure, enhancing reliability.

In this way, electric power of capacitor unit 216 is fed into vehicle load 210. Since the voltage of main power-supply 213 is below the predetermined voltage (i.e., capacitor unit 216 has a voltage higher than main power-supply 213), power switch 211 prevents electric power of capacitor 216 from flowing into main power-supply 213.

Vehicle load 210 can be continuously driven by the power-supply backup unit in case of emergency, the driver can control the vehicle and stop it with safety.

Here will be described the case where main power-supply 213 has recovery while capacitor unit 216 is supplying electric power to vehicle load 210. The operations in this case correspond to the process from step S56 in the interrupt routine. In step S56, the voltage-detecting circuit detects voltage V1 of main power-supply 213. As is in step S52, voltage V1 is compared to the predetermined voltage in step S57. If voltage V1 is greater than the predetermined voltage, "Yes" is taken at S57. In this case, the system judges that the voltage of main power-supply 213 has recovered and outputs a recovery signal to vehicle control CPU in step S58. In step S59, the system turns off first switch 217 and second switch 218 to switch the power supply from capacitor unit 216 back to main power-supply 213. In step S60, interruption call is set into the enabled mode. The flow of the process exits the interrupt routine and returns to the normal operations in the main routine.

On the other hand, if voltage V1 is lower than the predetermined voltage, "No" is taken at S57. In this case, the system judges that the voltage of main power-supply 213 has no recovery; capacitor unit 216 keeps supplying electric power to vehicle load 210. In the meantime, the voltage-detecting circuit detects decreasing voltage V3 of capacitor unit 216 in step S61. If voltage V3 is lower than the minimum level of the voltage for driving vehicle load 210, "No" is taken at S62. The system detects a low level of voltage of capacitor unit 216. In step S63, the system generates a warning signal indicating abnormality of auxiliary power-supply and returns the flow of the process to step S4 in the main routine to output the warning signal.

On the other hand, if voltage V3 is greater than the predetermined voltage, (i.e., "Yes" at S62), the system judges that capacitor unit 216 functions normally and returns the flow of the process to step S56 to judge whether main power-supply 213 has recovery or not.

The interrupt routine is carried out at frequent intervals (for example, a fraction of a second). If the voltage of main power-supply 213 drops below the predetermined voltage during the fault diagnosis operation of first switch 217 and second switch 218, the system immediately stops the operation and quickly turns on the two switches. Through the process, electric power is fed from capacitor unit 216 to vehicle load 210.

Upon recovery of main power-supply 213, the power supply device is switched back to main power-supply 213 from capacitor unit 216. The power supply device having an auxiliary power-supply thus provides reliable operations.

Like the structure described in the second embodiment, the structure provides the following advantages:
- highly accurate voltage-detection of capacitor unit 216 provides the apparatus with high reliability;
- employing relay, instead of diodes, for the two switches minimizes unwanted voltage-drop when capacitor unit 216 outputs electric power; and
- the fault diagnosis operation on the two switches increases reliability of the apparatus.

The structure of the embodiment carries out the fault diagnosis operation in the following order: diagnosis of a short-circuit failure in first switch 217 and second switch 218; diagnosis of open failure of first switch 217; and diagnosis of open failure of second switch 218. The diagnosis operation is not necessarily carried out in the order above. When detecting no open-failure in the switches, the system requires a predetermined wait (for example, 0.1 sec. in the embodiment) after turning off the switches, as is described in step S15 in Fig. 10A.

### (FOURTH EXEMPLARY EMBODIMENT)

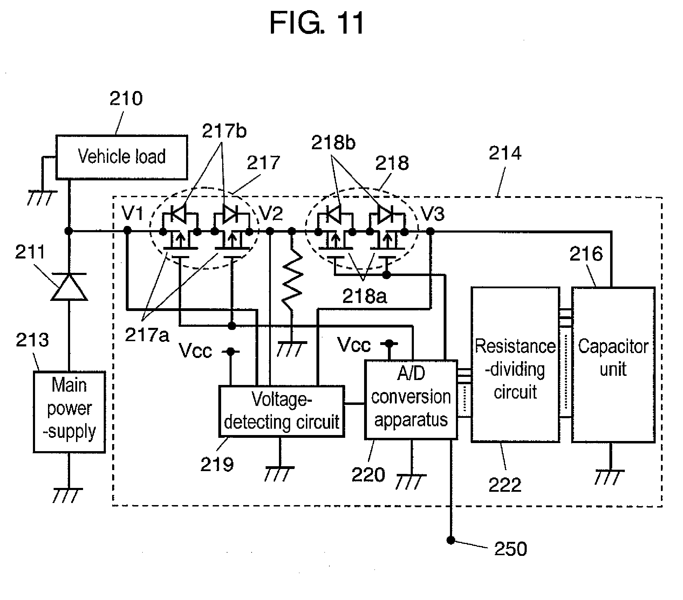

Fig. 11 is a circuit block diagram of a vehicle power-supply device using the A/D conversion apparatus in accordance with the fourth exemplary embodiment of the present invention. In Fig. 11, like parts are identified by the same reference marks as in Fig. 9 and the detailed description thereof will be omitted. The structure of the embodiment differs from that shown in Fig. 9 in the structure of the two switches; first switch 217 and second switch 218 are formed of a pair of p-channel field-effect transistors (FETs) 217a and a pair of p-channel FETs 218a, respectively, with each FET of a pair connected opposite in orientation. The two switches have 4 FETs in total. Since FETs 217a and FETs 218a are connected opposite in orientation, parasitic diode 217b (for FETs 217a) and parasitic diode 218b (for FETs 218a) are also oppositely disposed. FETs 217a and 218a are turned on/off selectively in pairs by A/D conversion apparatus 220. The structure having FETs 217a and 218a minimizes a voltage-drop when each of the switches turns on.

In the fault diagnosis operation under the state where first switch 217 is on and second switch 218 is off, when first switch 217 has no failure, voltage V1 nearly equals to voltage V2. The structure of the embodiment, since parasitic diode 218b is connected opposite to diode 217b, has no rush current flowing from the side of voltage V2 to the side of voltage V3, enhancing stability in voltage V2. As a result, the structure increases reliability of the fault diagnosis operation. The fault diagnosis operation of the embodiment has the same processes illustrated in Figs. 10A and 10B of the third embodiment and the detailed descriptions thereof will be omitted.

Like the structure described in the third embodiment, the structure provides the following advantages:
- highly accurate voltage-detection of capacitor unit 216 provides the apparatus with high reliability;
- employing a pair of FETs, instead of diodes, for the two switches minimizes unwanted voltage-drop when capacitor unit 216 outputs electric power; and
- fault diagnosis operations on the two switches increases reliability of the apparatus.

Although the structure of the embodiment employs a p-channel FET for a switch, it is not limited thereto; an n-channel FET also provides the same effect.

Compared to the relay used in the third embodiment, an FET with no mechanical contact further enhances reliability in switching operations.

Like in the third embodiment, the fault diagnosis operation has no particular order.

### (FIFTH EXEMPLARY EMBODIMENT)

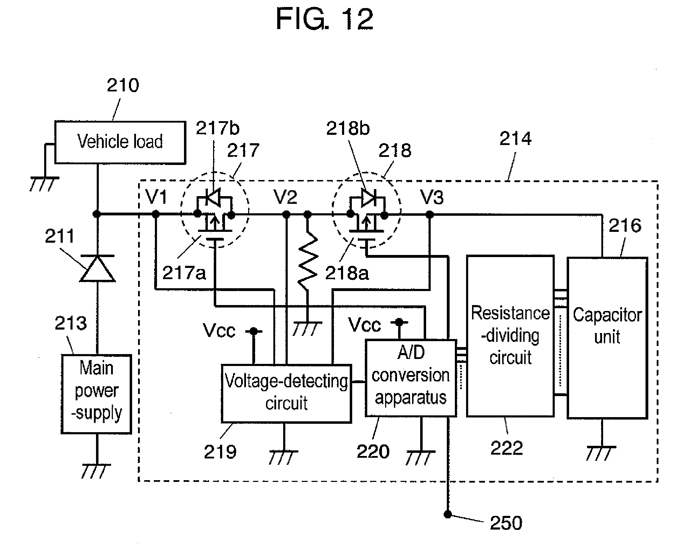

Fig. 12 is a circuit block diagram of a vehicle power-supply device using the A/D conversion apparatus in accordance with the fifth exemplary embodiment of the present invention. In Fig. 12, like parts are identified by the same reference marks as in Fig. 11 and the detailed description thereof will be omitted. The structure of the embodiment differs from that shown in Fig. 11 in the structure of the two switches; first switch 217 and second switch 218 are formed of a single p-channel FET 217a and a single p-channel FET 218a, respectively. The number of FETs can be halved, compared to four FETs in the fourth embodiment, contributing to cost-reduced production. However, the structure faces the problem of rush current. In the fault diagnosis operation under the state where first switch 217 is on and second switch 218 is off, when first switch 217 has no failure, voltage V1 nearly equals to voltage V2. However, parasitic second switch 218 has diode 218b in a direction shown in Fig. 12. If voltage V2 is greater than voltage V3 (V2 > V3), parasitic diode 218b brings second switch 218 into conduction. This allows rush current to flow into second switch 218, by which voltage V2 loses stability. This adversely affects reliability of the fault diagnosis operation. The problem above similarly occurs in the state where first switch 217 is off and second switch 218 is on.

To address the inconveniency above, the structure of the embodiment has a condition regarding voltage V1 (applied between vehicle load 210 and first switch 217) and voltage V3 (applied between second switch 218 and capacitor unit 216) so that the open-failure diagnosis operation is carried out only when the following condition is satisfied; if the absolute value of the difference between V1 and V3 (| V1 - V3 |) is greater than the predetermined value (as the least voltage-difference that permits rush current), the open-failure diagnosis operation on the two switches is not carried out.

In other words, under the aforementioned switching condition (where first switch 217 is on and second switch 218 is off), if the absolute value of the difference between V1 and V3 (| V1 - V3 |) is less than the predetermined value, that is, only when V1 nearly equals to V3, the open-failure diagnosis operation is carried out. Now suppose that voltage V1 nearly equals to voltage V3. At this time, when voltage V1 nearly equals to voltage V2 under the aforementioned switching condition, voltage V2 also nearly equals to voltage V3. That is, nearly equal voltages are applied on the both side of parasitic diode 218b. The fault diagnosis operation is carried out under a stable condition of voltage V2 with no rush current.

On the other hand, if the absolute value of the difference between V1 and V3 is equivalent to or greater than the predetermined value, the fault diagnosis operation on only short-circuit failure is carried out.

Vehicle load 210 is driven on a driving voltage defined in its specifications; voltage V1 has to be almost equivalent to voltage V3 while the vehicle power-supply device is functioning normally. Therefore, in a real-world situation, the case having no open-failure diagnosis operation unlikely occurs in the structure of the fifth embodiment. That is, the purpose of the present invention can be served by the structure shown in Fig. 12.

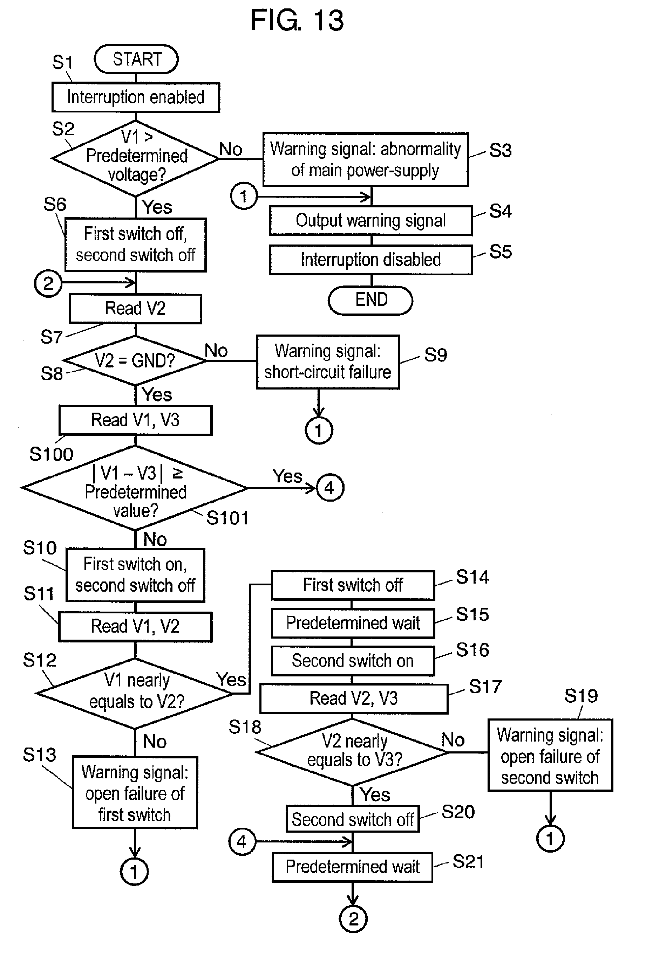

Next will be described the workings of the vehicle power-supply device when it carries out the fault diagnosis operation under the aforementioned condition, with reference to Fig. 13. Fig. 13 is a flow chart of the main routine illustrating the workings of the vehicle power-supply device using the A/D conversion apparatus in accordance with the fifth exemplary embodiment of the present invention. In Fig. 13, like processes are identified by the same step numbers as in Fig. 10A and the detailed description thereof will be omitted.

In the routine, step S1 through step S8 are the same as those of Fig. 10A. If no short-circuit failure occurs (i.e., "Yes" at S8), voltage-detecting circuit 219 detects voltage V1 and voltage V3 and transmits them to A/D conversion apparatus 220 (in step S100). In step S101, the absolute value of the difference between V1 and V3 (| V1 - V3 |) is compared to the specific value. If | V1 - V3 | is equivalent to or greater than the specific value (i.e., "Yes" at S101), the system skips the routine for open-failure diagnosis (S10 through S20) to avoid rush current that adversely affects reliability of the fault diagnosis operation. Therefore, the flow of the process goes to step S21. On the other hand, if | V1- V3 | is less than the predetermined value (i.e., "No" at S101), the system carries out the open-failure diagnosis operation with no worry of rush current.

The processes off the open-failure diagnosis operation (S10 through S20) are the same as those of Fig. 10A. The interrupt routine of the structure is the same as that of Fig. 10B.

The workings of the device ensures an accurate open-failure diagnosis operation, providing the diagnosis operation with high reliability.

Like the structure described in the fourth embodiment, the structure provides the following advantages:
- highly accurate voltage-detection of capacitor unit 216 provides the apparatus with high reliability;
- employing FETs, instead of diodes, for the two switches minimizes unwanted voltage-drop when capacitor unit 216 outputs electric power; and
- an accurate fault diagnosis operation on the two switches-with a restraint on the operating conditions-increases reliability of the apparatus.

Although the structure of the embodiment employs a p-channel FET for a switch, it is not limited thereto; an n-channel FET also provides the same effect.

Like in the third embodiment, the fault diagnosis operation has no particular order.

### INDUSTRIAL APPLICABILITY

The A/D conversion apparatus corrects digital output with the use of reference error properly selected from two or more reference errors, providing highly accurate error-correction. Not only as an analog-to-digital converter, the structure serves as a highly accurate voltage-monitor when it is used for a vehicle power-supply device. The monitoring performance with high accuracy is greatly effective in switching between the power supply and the backup unit for feeding electric power to the vehicle load in case of emergency.

## Claims

1. An A/D conversion apparatus comprising:
an A/D converter for converting analog input voltage into digital output;
a reference-voltage source connected to the A/D converter via a selector; and
a microcomputer that has a connection to the selector and reads the digital output and outputs corrected digital output through calculation, wherein the microcomputer has following steps in the calculation;
- calculating a plurality of digital outputs respectively obtained at a plurality of reference voltages fed from the reference-voltage source while switching the selector;
- determining each error used for error correction in a manner that previously obtained true values corresponding to the plurality of digital outputs are subtracted from the digital outputs, wherein, the error-determining step has a step of calculating a reference error to be applied to a digital-output range that is divided by the digital outputs corresponding to the reference voltages, the reference error is determined differently according to the following condition: when the errors obtained at adjacent reference voltages have same signs, the reference error is determined as an average of the errors obtained at adjacent reference voltages, whereas, when the errors obtained at adjacent reference voltages have different signs, the reference error is determined to be zero; and
- obtaining a corrected digital output by subtracting the reference error-which is applied to the digital-output range including the digital output-from the digital output corresponding to the analog input voltage of arbitrary magnitude received by the A/D converter.

2. The A/D conversion apparatus of claim 1, wherein the corrected digital output is calculated by subtracting the error applied to the reference voltage from the digital output, when the digital output corresponding to the analog input voltage of arbitrary magnitude equals to any one of the digital outputs corresponding to respective reference voltages.

3. The A/D conversion apparatus of claim 1, wherein setting of the plurality of the reference voltages is concentrated around an analog-input range that requires high accuracy.

4. The A/D conversion apparatus of claim 1, wherein the A/D converter is built in the microcomputer.

5. A vehicle power-supply device comprising:
a vehicle load;
a main power-supply for supplying driving power to the vehicle load;
a power-supply backup unit for supplying the driving power to the vehicle load if the main power-supply has a voltage-drop below a predetermined voltage, the power-supply backup unit further including:
a capacitor unit formed of a plurality of capacitors as an auxiliary power-supply;
a charging circuit for power-charging the capacitor unit;
a discharging circuit for power-discharging the capacitor unit;
a power-supply selector switch for switching between the main power supply and the capacitor unit;
a controller for controlling the charging circuit, the discharging circuit and the power-supply selector switch; and
the A/D conversion apparatus of claim 1 for detecting voltage of the plurality of capacitors.

6. The vehicle power-supply device of claim 5, wherein the controller is built in the microcomputer of the A/D conversion apparatus.
